# EUROPÄISCHE PATENTSCHRIFT

(11) **EP 1 364 412 B1**
(45) Veröffentlichungstag und Bekanntmachung des Hinweises auf die Patenterteilung: **07.11.2007**
(21) Anmeldenummer: 02744889.3
(22) Anmeldetag: 28.02.2002
(51) Int. Cl.: H01L 31/0203, H01L 27/146, H01L 31/0232, H04N 5/225

(54) **DIGITALE KAMERA MIT EINEM EMPFINDLICHEN SENSOR**
DIGITAL CAMERA COMPRISING A LIGHT-SENSITIVE SENSOR
CAMERA NUMERIQUE A DETECTEUR SENSIBLE

(30) Priorität: 28.02.2001 DE 10109787
(43) Veröffentlichungstag der Anmeldung: 26.11.2003
(73) Patentinhaber: Infineon Technologies AG, 81669 München (DE)
(72) Erfinder: PETZ, Martin, 85411 Eglhausen (DE); STADLER, Bernd, 93093 Donaustauf (DE); PAULUS, Stefan, 93197 Zeitlarn (DE); SCHRÖDER, Martin, 93093 Donaustauf (DE); LOSEHAND, Reinhard, 80637 München (DE); SCHAFFER, Josef-Paul, 81245 München (DE)
(74) Vertreter: Schweiger, Martin
(86) Internationale Anmeldenummer: PCT/DE2002/000708
(87) Internationale Veröffentlichungsnummer: WO 2002/069618

(56) Entgegenhaltungen:
- EP-A- 0 634 800
- EP-A- 0 840 502
- WO-A-01/91193
- US-A- 4 024 397
- US-A- 5 040 868
- US-A- 5 274 456

## Beschreibung

Die Erfindung betrifft eine digitale Kamera mit einem Kameragehäuse, einer Linse, die eine Linsenoberseite und eine Linsenunterseite aufweist, und mit einem lichtempfindlichen Sensor, der eine zur Linse ausgerichtete Oberseite und eine Unterseite aufweist, entsprechend der Gattung der unabhängigen Ansprüche.

Die fortschreitende Verbesserung und Intensivierung der Kommunikation in den unterschiedlichsten Netzen erhöht den Bedarf an visuellen Übertragungen von einem Teilnehmer zum anderen Teilnehmer eines Kommunikationsnetzes. Für eine visuelle Übertragung sind digitale Kameras erforderlich, die das empfangene Bild in digitale Pixel auflösen, welche dann über das Netzwerk übertragen werden können. Derartige Kameras sind teuer und für den Endverbraucher, das heißt, für den Nutzer von PCs, teilweise noch unerschwinglich.

Eine Bildaufnahmevorrichtung mit einer Vielzahl von Linsen aus Kunststoff und einem Sensor; die für eine Videokamera geeignet ist, ist aus der US 5,274,456 bekannt. Ein Behälter zur Aufnahme der Linsen und dem Sensor, die zu einander ausgerichtet werden sollen, ist vorgesehen.

Eine Bildaufnahmevorrichtung mit einer Anordnungen von Bildelementen und dazugehörigen Linsenselementen ist aus der EP 0 634 800B1 bekannt.

Ein Infrarotdetektor mit einer Linse ist aus der US 4,024,397 bekannt.

Aufgabe der Erfindung ist es, eine digitale Kamera zu schaffen, die preiswert herzustellen ist und die eine brauchbare Auflösung liefert.

Gelöst wird diese Aufgabe mit den Merkmalen der unabhängigen Ansprüche. Merkmale vorteilhafter Ausführungsformen ergeben sich aus den abhängigen Ansprüchen.

Erfindungsgemäß weist die digitale Kamera ein Kameragehäuse, eine Linse, die eine Linsenoberseite und eine Linsenunterseite aufweist, und einen lichtempfindlichen Sensor auf, der eine zur Linse ausgerichtete Oberseite und eine Unterseite aufweist. Die digitale Kamera ist soweit miniaturisiert, dass eine Vielzahl von digitalen Kameras aus einer Kunststoffplatte von weniger als 5 mm Dicke herstellbar wird.

Das Kameragehäuse weist einen Kunststoffkörper auf, der auf seiner Oberseite die Linse trägt und auf seiner Unterseite als lichtempfindlichen Sensor einen Halbleitersensor aufweist. Dabei weist die Kamera einen transparenten Kunststoffkern, der den Zwischenraum zwischen der Linsenunterseite und der Oberseite des Halbleitersensors ausfüllt, auf. Eine kreisförmige Apertur ist zwischen Linsenunterseite und Oberseite des Halbleitersensors in dem transparenten Kunststoffkern angeordnet. Diese digitale Kamera hat den Vorteil, dass nicht nur ihre Größe minimiert ist, sondern auch die Anzahl der lichtbrechenden Übergänge praktisch auf zwei Flächen reduziert ist. Der erste lichtbrechende Übergang ist an der Oberseite der Linse und der zweite lichtbrechende Übergang an dem Übergang von dem transparenten Kunststoffkern zu dem Halbleitersensor vorgesehen. Weitere lichtbrechende Übergänge werden bei dieser erfindungsgemäßen Konstruktion vermieden, um einerseits einen kompakten Aufbau der digitalen Kamera zu gewährleisten und andererseits Mehrfachreflektionen und Streumechanismen in der Kamera zu vermeiden. Durch die Beschränkung der lichtbrechenden Übergänge auf lediglich zwei Übergänge werden aufwändige und kostenintensive Vergütungen der Linsenoberflächen bzw. der Übergänge vermieden.

Durch die weitere Beschränkung auf derart miniaturisierte Abmessungen, dass die Höhe der Kamera in einer Kunststoffplatte unterbringbar ist, die eine Dicke von weniger als 5 mm aufweist, sind darüber hinaus Farbkorrekturmaßnahmen entbehrlich. Aufgrund des transparenten Kunststoffkerns, der in seinem Lichtbrechungsindex dem Lichtbrechungsindex der Kunststofflinse entspricht, wird praktisch die Anzahl der lichtbrechenden Oberflächen auf die lichtbrechende Oberfläche der Linsen wegen des Ausfüllens des Zwischenraumes zwischen Linse und Oberfläche des Halbleitersensors reduziert. Dazu wird der Kunststoffkern von dem Kunststoffkörper des Kameragehäuses vollständig eingeschlossen, so dass der einfallende Lichtstrahl nach dem Brechen an der Vorderseite der Linse bis zum Auftreffen auf die Oberseite des Halbleitersensors vollständig in transparentem Kunststoff mit identischem Brechungsindex wie die Linse geführt wird.

Der Halbleitersensor selbst weist auf seiner Oberseite eine Matrix von lichtempfindlichen Zellen auf. Die Elektroden dieser lichtempfindlichen Zellen sind über integrierte Schaltungen mit Kontaktflächen verbunden. Diese integrierten Schaltungen ermöglichen es, aus den parallel anstehenden Signalen an jedem Pixel des Bildes ein seriell abfragbares Signal zu erzeugen, das über eine Umverdrahtungsstruktur zu Außenanschlüssen geleitet wird. Dabei ist die Anzahl der Außenanschlüsse soweit miniaturisiert, dass im Prinzip ein Signalanschluss und zwei Versorgungsanschlüsse für die digitale Kamera vorzusehen sind. Für besondere Anwendungen kann die Anschlusszahl ohne weiteres erhöht werden. Jedoch steht aufgrund der miniaturisierten Fläche der Unterseite der Kamera nur ein sehr begrenzter Bereich für elektrische Anschlüsse zur Verfügung.

In einer Ausführungsform der Erfindung ist der Kunststoffkörper aus lichtabsorbierendem Kunststoffmaterial hergestellt und umgibt einen kegelstumpfförmigen transparenten Kunststoffkern in seinem Zentrum. Aufgrund der Kegelstumpfform wird an der Spitze des Kegelstumpfes eine eingeengte Öffnung, die gleichzeitig als Apertur der digitalen Kamera dient, erreicht. Die Grundfläche des Kegelstumpfes ist größer als die Fläche der Apertur, die von der Kegelstumpfspitze gebildet wird, und somit ist es vorteilhaft möglich, unterschiedliche digitale Kameras zu realisieren, deren Öffnungswinkel an die Anwendungen anpassbar ist.

Bei einer weiteren Ausführungsform der Erfindung ist der lichttransparente Bereich nicht allein auf den mindestens lichttransparenten Kernbereich der Kamera beschränkt, sondern der gesamte Kunststoffkörper weist lichttransparentes Material auf. Mit einer derartigen Kamerakonstruktion wird das Herstellungsverfahren für die Kamera wesentlich vereinfacht, da eine durchgängige lichttransparente Kunststoffplatte für die Ausbildung der Kamera einsetzbar wird.

Die Position der Apertur innerhalb des Kameragehäuses ist mitentscheidend für eine optimale Erfassung des Bildes in der Kamera. In einer weiteren Ausführungsform der Erfindung liegt deshalb der Abstand zwischen der Linsenoberseite und einer entsprechenden Lochblende für die Apertur zwischen einer Hälfte und einem Drittel des Abstandes zwischen Linsenoberseite und der Oberseite des Halbleitersensors. Grundsätzlich sind zwar auch Aperturen oberhalb der Linse, das heißt, außerhalb des erfindungsgemäßen Kameragehäuses, denkbar, jedoch besteht die Gefahr des Eindringens von Streulicht in die Kamera, so dass derartig außerhalb des Kamerasystems angeordnete Aperturen durch einen zusätzlichen Tubus vor Streulicht geschützt werden müssen, so dass die Kameraherstellung unnötig verteuert würde.

Die Realisierung der erfindungsgemäßen Kamera ist derart preiswert, da zur Darstellung einer Farbkamera lediglich vier Kameras des erfindungsgemäßen Typs, nämlich eine Kamera für das Schwarz-Weiß-Signal und drei Kameras für die drei Farbkomponenten, vorzusehen sind, und über eine entsprechende logische und kontinuierliche Auswertung können die Farbsignale der einzelnen Kameras und das Schwarz-Weiß-Signal wieder zu einem Bild kombiniert werden.

Eine weitere Ausführungsform der Erfindung sieht vor, dass die Umverdrahtungsstruktur auf der Unterseite des Kunststoffkörpers angeordnet ist. Diese Anordnung der Umverdrahtungsstruktur auf der Unterseite des Kunststoffkörpers bringt den Vorteil mit sich, dass wesentlich mehr Fläche zur Verfügung steht als unmittelbar auf der Rückseite des Halbleiterchipsensors. Gleichzeitig kann die Umverdrahtungsfolie derart in die Öffnung für den Halbleitersensor auf der Unterseite des Kunststoffkörpers eingearbeitet sein, dass beim Einkleben des Halbleitersensors mit seinen auf der Oberseite befindlichen Kontaktflächen in die vorbereitete Öffnung auf der Unterseite des Kunststoffkörpers gleichzeitig eine Kontaktierung mit der Umverdrahtungsstruktur auf der Unterseite des Kunststoffkörpers erreicht wird.

Eine weitere Ausführungsform der Erfindung sieht vor, dass die Umverdrahtungsstruktur auf der Unterseite des Halbleitersensors angeordnet ist. Diese Ausführungsform der Erfindung hat den Vorteil, dass die gesamte Umverdrahtungsstruktur bereits beim Herstellen des Halbleitersensors berücksichtigt werden kann und somit aufwändige Schritte zur Herstellung einer Umverdrahtungsstruktur auf der Unterseite des Kunststoffkörpers vermieden werden. Diese Ausführungsform ist jedoch nur so lange vorteilhaft anwendbar, solange die Größe des Halbleitersensors das Anbringen von Außenanschlüssen in geeigneter Schrittweite für eine Weiterverarbeitung in einem Kommunikationsgerät zulässt.

Sind größere Strukturen der Außenanschlüsse erforderlich, so kann in einer weiteren Ausführungsform der Erfindung die Umverdrahtungsstruktur ein Systemträger sein, auf dem der miniaturisierte Halbleitersensor montiert ist. Ein derartiger Systemträger mit entsprechenden Umverdrahtungsstrukturen kann in seiner Größe den erforderlichen Schrittweiten für Außenkontaktanschlüsse angepasst werden, um einen entsprechenden Abgriff der Signalspannungen und einen entsprechenden Anschluss der Versorgungsspannung für den Halbleitersensor der digitalen Kamera zu ermöglichen.

In einer weiteren Ausführungsform der Erfindung ist die Linse von einer Lichtschutzmaske umgeben, die dafür sorgt, dass kein Streulicht in die digitale miniaturisierte Kamera einfallen kann. Diese Lichtschutzmaske kann so weit verkleinert werden, dass nur noch ein Teilbereich der Linse für die Abbildung zur Verfügung steht, so dass die Lichtschutzmaske praktisch eine weitere Apertur darstellt und damit die Abbildungsqualität verbessert.

Bei einer weiteren Ausführungsform der Erfindung ist es vorgesehen, dass die Umverdrahtungsstruktur Leiterbahnen aufweist, welche die Kontaktflächen des Halbleitersensors mit Außenanschlüssen auf der Unterseite der Kamera verbindet. Somit hat die Kamera den Vorteil, dass sie vom Anwender oder Benutzer lediglich in einen Sockel zu stecken ist. Dieser Sockel weist auf seiner Unterseite entsprechende Steckkontakte, die mit den Außenanschlüssen auf der Unterseite der Kamera kommunizieren auf. In dieser Weise wird dem Benutzer ein visueller Austausch von Informationen in einem Kommunikationsnetz ermöglicht.

Dazu können in einer weiteren Ausführungsform der Erfindung die Außenanschlüsse Kontakthöcker aufweisen. Diese Kontakthöcker sind in relativ einfacher Weise realisierbar und können deshalb äußerst preiswert eingesetzt werden.

Eine weitere Ausführungsform der Erfindung sieht vor, dass die digitale Kamera als Umverdrahtungsstruktur einen Systemträger aufweist, der den Halbleitersensor trägt und elektrische Außenkontakte aufweist, wobei die Kontaktflächen des Halbleitersensors über Bondverbindungen mit den Außenanschlüssen verbunden sind. Dabei sind die Bondverbindungen innerhalb des Kunststoffkörpers der Kamera angeordnet und lediglich die Außenanschlüsse bleiben auf der Unterseite der Kamera oder seitlich im unteren Bereich der Kamera für einen elektrischen Abgriff zugänglich. Aufgrund der Wahlmöglichkeit eines seitlichen Zugriffs auf die Außenanschlüsse oder eines Zugriffs auf der Unterseite der digitalen Kamera zu den Außenanschlüssen ist die Ausführungsform der Erfindung mit einem Systemträger besonders vorteilhaft.

Eine weitere Ausführungsform der Erfindung sieht vor, dass die digitale Kamera einen Kunststoffkörper aufweist, der mit der Linse einen gemeinsamen Kunststoffkörper aus transparentem Kunststoff bildet. Diese Ausführungsform der Erfindung hat den Vorteil, dass die Linse unmittelbar an den Kunststoffkörper angegossen werden kann und somit keinerlei optische Übergänge zwischen einem Kernbereich des Kunststoffkörpers und einer Linse aus Kunststoff vorzusehen sind. Vielmehr bildet nun die gesamte digitale Kamera einen inneren Block, der lediglich durch eine zwischen dem Linsenbereich und der Oberfläche des Halbleitersensors angeordnete Apertur strukturiert wird. Eine derartige digitale Kamera, die vollständig bis auf eine Lochblende für eine Apertur aus einem transparenten Kunststoffblock besteht, empfängt über die Außenflächen Streulicht, was ein Bildrauschen zur Folge hätte. Aus diesem Grunde ist es vorteilhaft, eine derartige Kamera lichtdicht in eine Fassung einzubauen, die in einem Gehäuse eines tragbaren Fernsprechgeräts oder im Gehäuse eines Rechners oder im Gehäuse eines Bildschirms usw. vorgesehen werden kann.

In einer weiteren Ausführungsform der Erfindung ist der transparente Kunststoffkörper einer digitalen Kamera von einer Lichtschutzfolie unter Freilassung einer Öffnung für die Linse bedeckt. Eine derartige Lichtschutzfolie kann aus einem mit Füllstoff versehenen transparenten Kunststoff hergestellt und als Schrumpffolie auf den transparenten Kunststoffkörper der digitalen Kamera aufgeschrumpft werden. Diese Ausführungsform der Erfindung hat den Vorteil, dass die Kamera auch ohne Einbau in eine lichtdichte Fassung funktionsfähig ist.

Der Halbleitersensor kann in einer weiteren Ausführungsform der Erfindung auf einem Systemträger mit einem Klebstoff wie einem Leitkleber montiert sein. In einer weiteren Ausführungsform der Erfindung kann der Halbleitersensor mittels eines Klebstoffs auf der Unterseite des Kunststoffkörpers montiert sein, in beiden Fällen wird ein lichttransparenter Kunststoff eingesetzt, um die Sensorfläche des Halbleitersensors nicht zu beeinträchtigen. Auch die Linse kann mit einem entsprechenden transparenten Klebstoff auf der Oberseite des Kunststoffkörpers in der entsprechend vorgesehenen Öffnung montiert sein. Dabei kann mit dem Einbringen der Linse in die Öffnung gleichzeitig jeglicher Hohlraum zwischen der Oberfläche des Halbleitersensors und der Linsenunterseite mit transparentem Klebstoff ausgefüllt sein, so dass in einem Arbeitsgang mit der Montage der Linse auch der transparente Kunststoffkern realisiert werden kann.

Ein Verfahren zur Herstellung einer digitalen Kamera erfordert zunächst ein Bereitstellen einer Spritzgußform, die mindestens eine Kavität zum Spritzgießen einer Kunststoffplatte für mehrere Kameragehäuse einer digitalen Kamera aufweist. Die Kunststoffplatte weist darüber hinaus passende Öffnungen auf ihrer Oberseite zur Aufnahme einer Linse und auf ihrer Unterseite zur Aufnahme eines Halbleitersensors auf. Diese Öffnungen werden mit der einen Spritzgußform verwirklicht.

Danach erfolgt ein Bestücken der Unterseite der Kunststoffplatte mit Halbleitersensoren, Umverdrahtungsstrukturen und Außenanschlüssen. Schließlich wird der Kunststoffkern des Kunststoffkörpers mit transparentem Klebstoff aufgefüllt und gleichzeitig die Oberseite der Kunststoffplatte mit Linsen in den dafür vorgesehenen Öffnungen bestückt. Mit dem Eindrücken der Linsen in die dafür vorgesehenen Öffnungen wird gleichzeitig der transparente Klebstoff in dem Kunststoffkern verteilt und in sämtliche Winkel und Ecken gedrückt. Zur Erleichterung dieser Montage können Entlüftungsöffnungen vorgesehen sein, falls die Montage nicht unter Vakuum erfolgt.

Da der Kunststoffkörper bei diesem Verfahren nicht aus einem nichttransparenten Kunststoffkörper, sondern aus einer Kunststoffmasse besteht, wie sie auch zum Verpacken von elektronischen Bauteilen verwendet werden kann, wird zur Vermeidung von Streulicht im Bereich der Montageöffnung für die Linse eine Lichtschutzmaske unter Freilassung der Linse auf der Oberseite der Kunststoffplatte vorgesehen. Nach dem Aufbringen dieser Lichtschutzmaske auf die Oberseite der Kunststoffplatte kann die Kunststoffplatte in einzelne digitale Kameras getrennt werden. Aufgrund der Undurchlässigkeit des Kunststoffkörpers für Licht ist nach dem Trennen der digitalen Kamera aus der Kunststoffplatte diese unmittelbar funktionsfähig. Ferner hat dieses Verfahren den Vorteil, dass die Funktionsfähigkeit der Kameras noch vor dem Trennen der Kunststoffplatte getestet werden kann.

Bei einem bevorzugten Durchführungsbeispiel des Verfahrens erfolgt das Bestücken der Unterseite der Kunststoffplatte mit Halbleitersensoren, die Außenkontakthöcker aufweisen, mittels Flip-Chip-Technologie in die dafür vorgesehenen Öffnungen. Bei dieser Verfahrensvariante trägt praktisch der Halbleitersensor bereits die Außenanschlüsse auf seiner Unterseite, so dass eine einfache Endmontage ermöglicht wird.

Ein weiteres Durchführungsbeispiel des Verfahrens sieht vor, dass das Auffüllen eines kegelstumpfförmigen Kunststoffkerns innerhalb des Kunststoffkörpers mit transparentem Kunststoff unter Vakuum durchgeführt wird. Dieses Verfahren hat den Vorteil, dass in dem Kunststoffkörper, der gleichzeitig das Kameragehäuse bildet, keine Entlüftungsöffnungen vorzusehen sind, da unter Vakuum problemlos sämtliche Hohlräume im Kernbereich der Kamera mit transparentem Kunststoff aufgefüllt werden können.

Ein alternatives Verfahren zur Herstellung einer digitalen Kamera sieht vor, dass ein Systemträger für mehrere Halbleitersensoren und mit Flachleitern für Außenanschlüsse bereitgestellt wird. Bei diesem Verfahren werden die Halbleitersensoren auf dem Systemträger aufgebracht und die Kontaktflächen auf der Oberseite des Halbleitersensors werden mit den Außenanschlüssen durch entsprechende Verbindungsdrähte oder Verbindungsleitungen miteinander verbunden. Nach diesem Vorgang erfolgt ein Vergießen des Systemträgers mit einem transparenten Kunststoff zu einer transparenten unteren Kunststoffplattenhälfte unter Einbetten des Systemträgers, der Außenanschlüsse und der Verbindungen auf der Unterseite der Kunststoffplatte.

Anschließend kann ein selektives Beschichten der Oberseite dieser unteren Kunststoffplattenhälfte mit einer Lochblendenschicht erfolgen. Dabei wird jeweils eine Lochblende mit der Sensorfläche des Halbleitersensors ausgerichtet. Nach dem selektiven Beschichten der Oberseite, so dass über jeder Sensorfläche eine Lochblende liegt, wird auf dieser Lochblendenschicht die weitere Kunststoffplattenhälfte aufgebracht. Bei diesem Aufbringen kann auf der Oberseite der Kunststoffplattenhälfte gleichzeitig eine transparente domförmige Auswölbung eingeformt werden. Alternativ können durch Laserabtrag oder Sputterabtrag entsprechende domartige Auswölbungen, die als Linsenoberfläche dienen können, auf der Oberseite der oberen Kunststoffplattenhälfte eingeformt werden.

Nach dem Ausbilden der oberen Kunststoffplattenhälfte mit integral eingebauten Linsen kann die gesamte transparente Kunststoffplatte in einzelne Kameragehäuse mit eingebauter integraler Linse und eingebautem Halbleitersensor sowie Außenanschlüssen getrennt werden. Nach dem Trennen ist das Kameragehäuse transparent, so dass Streulicht auf die Sensoroberfläche fallen kann und damit ein verrauschtes Bild erzeugt wird. Erst durch Einbau einer derartigen transparenten digitalen Kamera in eine lichtdichte Fassung wird die Abbildung perfekter. Eine weitere Verfahrensvariante besteht darin, den transparenten Kamerakörper durch Aufschrumpfen einer Lichtschutzfolie unter Freilassung einer Öffnung für die Linse auf den Außenseiten der transparenten digitalen Kamera vor Streulicht zu schützen.

Durch die kompakte Zusammenlegung eines Sensorchips und einer Verpackung entsteht eine miniaturisierte Kameraeinheit, die sich vor allem im Kommunikationsbereich einsetzen lässt. Dazu sind die Abmessungen minimal gehalten, so dass ein Einsatz in mobilen Telefonen, in Laptops und schnurlosen Fernsprechapparaten usw. möglich wird. Aufgrund der rationalen Herstellungsverfahren in Form von großflächigen Platten kann die erfindungsgemäße Kamera kostengünstig hergestellt werden. Schließlich ist aufgrund der Einheit von Verpackung und Linse eine Anwendung direkt auf einer Leiterplatte möglich, wobei für die Verarbeitung der erfindungsgemäßen Kamera Standardverarbeitungsverfahren einsetzbar sind. Die Anzahl der Eingangs- und Ausgangsanschlüsse im Seitenbereich oder Bodenbereich der erfindungsgemäßen Kamera kann der Anwendung durch flexible Verpackungsgrößen angepasst werden. Auch eine Flip-Chip-Technologie ist anwendbar, die eine Verdrahtung im und am Gehäuse entbehrlich macht und keinerlei offene Kontakte bei der Herstellung einsetzt.

Die Linse kann entweder als Einzelstück gespritzt werden oder in einer Matrix am Spritzling der Montage zugeführt werden. Diese Matrix wird auf den Kamerakörper aufgeklebt und danach kann der Kamerakörper lichtdicht abgedeckt werden. Ferner kann bei der vorgesehenen Halbierung des Gehäuses eine sehr genaue Positionierung von Linse, Apertur und Halbleitersensor erreicht werden. Die Apertur ist im Kamerakörper integriert und somit gegen Beschädigung und Dejustage geschützt. Der Kamerakörper kann als ein Array mittels Molding hergestellt werden. Die Montage des Sensorchips erfolgt in einer Ausführungsform der Erfindung mittels Flip-Chip-Bonding auf die Kontakte des Kamerakörpers. Nach der Montage des Halbleitersensors kann das Array in einzelne Kameras, beispielsweise durch Sägen, auftrennt werden.

Die Erfindung wird nun anhand von Ausführungsbeispielen mit Bezug auf die anliegenden Figuren näher erläutert.
- Figur 1: zeigt einen schematischen Querschnitt einer ersten Ausführungsform der Erfindung.
- Figur 2: zeigt einen schematischen Querschnitt einer zweiten Ausführungsform der Erfindung.
- Figur 3: zeigt einen schematischen Querschnitt einer vierten Ausführungsform der Erfindung.
- Figur 4: zeigt schematisch Verfahrensschritte zur Herstellung der zweiten Ausführungsform der Erfindung.
- Figur 5: zeigt schematisch eine Draufsicht auf eine plattenförmige Anordnung von mehreren Linsen für digitale Kameras einer Ausführungsform der vorliegenden Erfindung.
- Figur 6: zeigt einen schematischen Querschnitt eines Trägersubstrats, auf dem ein Systemträger galvanisch abgeschieden werden kann.
- Figur 7: zeigt einen schematischen Querschnitt eines Trägersubstrats und darauf abgeschiedene Komponenten eines Systemträgers.
- Figur 8: zeigt einen schematischen Querschnitt eines Systemträgers mit darauf angeordneten Halbleitersensoren und Bonddrahtverbindungen zu Außenanschlüssen.
- Figur 9: zeigt einen schematischen Querschnitt einer unteren transparenten Kunststoffplattenhälfte mit mehreren digitalen Kameras.
- Figur 10: zeigt im schematischen Querschnitt das Aufbringen einer Lochblendenschicht auf die untere transparente Kunststoffplattenhälfte.
- Figur 11: zeigt in einem schematischen Querschnitt das Aufbringen einer zweiten transparenten Kunststoffplattenhälfte mit eingeformten Linsen an der Oberseite der oberen Kunststoffplattenhälfte.
- Figur 12: zeigt eine schematische Querschnittsansicht der Figur 11 nach Abätzen des Trägersubstrats.
- Figur 13: zeigt einen schematischen Querschnitt eines herausgetrennten transparenten digitalen Kameraelementes.
- Figur 14: zeigt in einem schematischen Querschnitt die Herstellungsschritte einer transparenten digitalen Kamera der Ausführungsform der Figur 3.

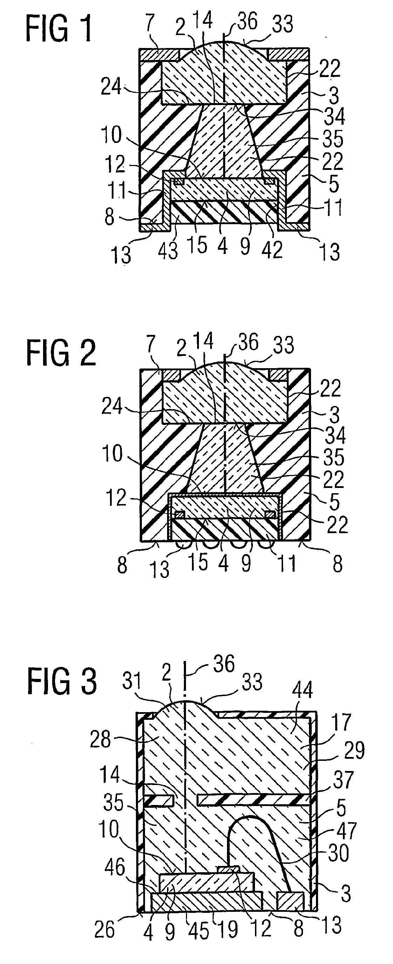

Figur 1 zeigt einen schematischen Querschnitt einer ersten Ausführungsform der Erfindung. Diese Ausführungsform ist praktisch dreigeteilt und zeigt eine digitale Kamera 1 mit einer Linse 2 an der Oberseite der Kamera, ein Kameragehäuse 3 und einen lichtempfindlichen Sensor 4 am Boden des Kameragehäuses. Die Linse 2 weist eine Vorderseite oder eine Linsenoberseite 33 auf und eine Linsenunterseite 34. Die Linse 2 ist in das Kameragehäuse 3 aus einem lichtundurchlässigen Kunststoffkörper 5 eingelassen und mit diesem Kunststoffkörper über einen Klebstoff 22 mechanisch verbunden. Dieser Klebstoff 22 ist ein transparenter Kunststoff, der auch den Kunststoffkern 35 des Kunststoffkörpers 5 zwischen Linsenunterseite 34 und Oberseite 10 des Halbleiters 9 füllt. Durch diesen transparenten Kunststoffkern 35 reduziert sich die Anzahl der lichtbrechenden Flächen der Kamera auf die Vorderseite der Linse 2 bzw. der Linsenoberseite 33 und die Oberseite 10 des Halbleitersensors 9. Da die Oberseite 10 des Halbleitersensors 9 planparallel zur Unterseite 34 der Linse 2 angeordnet ist, wird die Oberseite des Halbleitersensors lediglich mit einer Antireflexschicht vergütet, um den Reflektionsgrad zu vermindern und Mehrfachreflektionen zu dämpfen.

Der Halbleitersensor in der Ausführungsform der Figur 1 weist an seiner Oberseite 10 eine Matrix von lichtempfindlichen Zellen auf, deren Elektroden über integrierte Schaltungen mit Kontaktflächen 12 am Rand der Oberseite 10 des Halbleitersensors 9 verbunden sind. Diese Kontaktflächen 12 werden von außerhalb der Kamera über Kontaktanschlüsse 13 mit Strom versorgt bzw. liefern an die außenliegenden Kontaktanschlüsse 13 der Kamera über eine Umverdrahtungsstruktur 11 in der Aussparung 42 im Bodenbereich des Kunststoffkörpers 5 serielle Signale des mit der Oberfläche 10 des Halbleitersensors 9 aufgenommenen Bildes.

In der Ausführungsform der Figur 1 sind die Außenkontakte 13. auf der Unterseite 8 des Kunststoffkörpers 5 angeordnet und die Unterseite 15 des Halbleitersensors 9 ist mit einer Schutzschicht 43 vor Beschädigungen geschützt. Eine kreisförmige Apertur 14 ist zwischen der Linsenunterseite und der Oberseite 10 des Halbleitersensors 9 in dem transparenten Kunststoffkern 35 angeordnet und schnürt den Strahlengang des Lichtes ein, so dass Streulicht von der Oberseite 10 des Halbleitersensors 9 ausgeblendet wird. In dieser Ausführungsform der Figur 1 umgibt der Kunststoffkörper 5 aus lichtabsorbierenden Material einen kegelstumpfförmigen transparenten Kunststoffkern 35 im Zentrum 36 der digitalen Kamera 1. Der Abstand der als Lochblende ausgeführten Apertur 14 von der Linsenoberseite 33 liegt im Bereich zwischen einer Hälfte und einem Drittel des Abstandes zwischen Linsenoberseite 33 und der Oberseite 10 des Halbleitersensors 9. Das Öffnungsverhältnis der Linse 2 ist in dieser Ausführungsform mit 1 : 2,5 bei einem Objektivfeld von 20 Grad eingestellt. Die Brennweite der Linse ist in dieser Ausführungsform 1,3 mm und die Apertur hat einen Durchmesser von 0,29 mm, während die Abbildungsfläche oder lichtempfindliche Sensorfläche einen Durchmesser von 0,45 mm aufweist. Die Apertur ist in einem Bereich von 0,5 bis 0,9 mm von der Linsenoberseite 33 entfernt angeordnet und die Oberseite 10 des Halbleitersensors 9 ist in einer Entfernung zwischen 1,5 und 2,7 mm von der Linsenoberseite 33 positioniert. Der hier eingesetzte transparente Kunststoff weist Polycarbonat mit einem Brechungsindex von 1,59 auf. Es kann jedoch auch ein Kunststoffmaterial aus PMMA (Polymethylmethacrylat) eingesetzt werden, das einen Brechungsindex von 1,49 aufweist.

Die Vorderseite der Linse kann als asphärische Fläche ausgeführt sein, um Randverzerrungen zu minimieren, jedoch zeigt sich bei der geringen Brennweite und den geringen Abmessungen der digitalen Kamera aus Kunststoff keine wesentliche Verbesserung gegenüber einer sphärisch ausgeformten Linsenoberseite 33. Die Oberseite der digitalen Kamera der Ausführungsform der Figur 1 ist auf ihrer Oberseite mit einer Lichtschutzmaske 7 ausgestattet, welche die Linse 2 vollständig umgibt, um Streulicht abzuschirmen und lediglich die gewölbte Vorderseite der Linse freizuhalten. Diese Öffnung wirkt gleichzeitig wie eine zusätzliche Apertur im optischen Strahlengang.

Figur 2 zeigt einen schematischen Querschnitt einer weiteren Ausführungsform der Erfindung. Komponenten in Figur 2, die gleiche Funktionen wie Komponenten in Figur 1 aufweisen, werden mit gleichen Bezugszeichen gekennzeichnet und nicht extra erläutert.

Der wesentliche Unterschied zwischen der Ausführungsform der Figur 1 und der Figur 2 besteht darin, dass der Halbleitersensor auf seiner Unterseite 15 eine Umverdrahtungsstruktur 11 aufweist, die mit den Kontaktflächen im Randbereich der Oberseite 10 des Halbleitersensors 9 in Verbindung steht. Eine derartige Verbindung kann mittels Durchkontakten durch den Halbleiterchip des Halbleitersensors geschaffen werden.

Die Unterseite der Umverdrahtungsstruktur 11 trägt als Außenanschlüsse 13 Kontakthöcker, die auf Kontaktanschlussflächen der Umverdrahtungsstruktur aufgelötet sind. Somit kann über die Kontakthöcker der Halbleitersensor 9 versorgt werden und Signale von den Kontaktflächen 12 des Halbleitersensors 9 zu den Kontakthöckern geführt werden und von diesen in serieller Form abgegriffen werden. Der übrige Aufbau der Ausführungsform der Figur 2 entspricht dem Aufbau der Figur 1. Auch hier ist der optische Strahlengang innerhalb der digitalen Kamera durchgängig ohne zusätzliche strahlenbrechende Oberfläche aus transparentem Kunststoff hergestellt.

Figur 3 zeigt einen schematischen Querschnitt einer dritten Ausführungsform der Erfindung. Komponenten, die gleiche Funktionen wie in den Figuren 1 und 2 erfüllen, werden mit gleichen Bezugszeichen gekennzeichnet und nicht extra erläutert.

Die Ausführungsform der Figur 3 unterscheidet sich von den Ausführungsformen der Figuren 1 und 2 dadurch, dass die elektronische Kamera aus einem homogenen Block aus transparentem Kunststoff besteht. Dieser Block weist auf seiner Oberseite eine Auswölbung 31 auf, die als Linsenoberseite 33 ausgebildet ist und entweder asphärisch oder sphärisch geformt ist. Der transparente Kunststoffblock weist zwischen der Hälfte des Abstandes von der Linsenoberseite zu der Oberseite 10 des Halbleitersensors 9 und einem Drittel dieses Abstandes eine Lochblende 37 auf, die im Zentrum 36 des Strahlenganges der elektronischen Kamera 1 eine Apertur 14 aufweist. Mit dieser Apertur 14 werden Mehrfachreflektionen und Streulicht vermindert. Das Zentrum 36 der elektronischen Kamera stellt gleichzeitig die optische Achse dar. Der transparente Kunststoffblock 44 kann auf seiner Unterseite einen Halbleitersensor 9 mit Umverdrahtungsstruktur 11 wie in den vorhergehenden Ausführungsformen der Figuren 1 und 2 aufweisen. In dieser Ausführungsform ist jedoch die Umverdrahtungsstruktur auf einem Systemträger 19 ausgebildet. Dieser Systemträger 19 trägt einerseits den Halbleitersensor 9 auf einer Kontaktplatte 45, die mit ihrer Unterseite gleichzeitig als einer der Außenanschlüsse dienen kann, wenn der Halbleitersensor 9 mittels einer Leitkleberschicht 46 auf der Kontaktplatte 45 montiert ist.

Neben der Kontaktplatte 45 für den Halbleitersensor 9 sind Außenanschlusselemente 13 angeordnet, die in die transparente Kunststoffmasse 47 des Kunststoffblockes 44 isoliert von der Kontaktplatte 45 eingegossen sind. Die Außenanschlüsse 13 sind über Bonddrähte 30 mit den Kontaktflächen 12 auf dem Halbleitersensor 9 verbunden. Der transparente Kunststoffblock 44 dieser Ausführungsform der Erfindung kann gegen Streulicht durch Einbau in eine entsprechende lichtundurchlässige Fassung geschützt werden. In dieser Ausführungsform der Figur 3 ist eine dünne lichtundurchlässige Schrumpffolie als Gehäuse 3 auf den transparenten Kunststoffblock unter Aussparung der Öffnung für die Linse 2 und unter Aussparung der Außenanschlüsse 13 aufgeschrumpft.

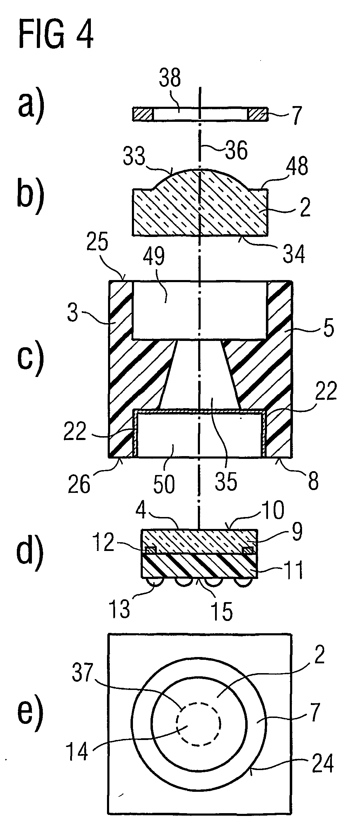

Figur 4 zeigt in den Unterfiguren a) bis e) schematische Verfahrensschritte bzw. Komponenten zur Herstellung der zweiten Ausführungsform der Erfindung, wie sie in Figur 2 gezeigt wird.

Zunächst wird mit Figur 4a eine Lichtschutzfolie 7 gezeigt, die aus lichtundurchlässigem Kunststoff hergestellt ist und kreisförmige Öffnungen 38 aufweist, die der Auswölbung der Linse angepaßt sind.

In Fig. 4b wird eine aus einem transparenten Kunststoff geformte Linse 2 gezeigt, die einen scheibenförmigen Randabsatz 48 aufweist, der planparallel zur Linsenunterseite 34 angeordnet ist. Die Brennweite dieser Linse ist in dieser Ausführungsform 1,3 mm, wobei die Linse aus PMMA hergestellt ist. Dieses Material weist einen Brechungsindex von 1,49 auf und kann mit Optik-UV-Kitt in einer dafür vorgesehenen Öffnung montiert werden. Dieser Optik-UV-Kitt ist in seinem Brechungsindex dem transparenten Linsenkunststoff angepasst.

Figur 4c zeigt einen Kunststoffkörper 5, der aus lichtundurchlässigem Kunststoffmaterial hergestellt ist und an seiner Oberseite eine Öffnung 49 aufweist, die der in Figur 4b gezeigten Linse 2 angepasst ist. Der Kunststoffkörper 5 wird an der Unterseite der Linse 34 eingeschnürt und bildet damit eine Apertur 14 für die digitale Kamera. Auf der Unterseite 8 des Kunststoffkörpers 5 ist eine Öffnung 50 des Kunststoffkörpers 5 angeordnet, die der Aufnahme eines Halbleitersensors dient. Zwischen den beiden Öffnungen 50 und 49 auf der Unterseite 8 und der Oberseite des Kunststoffkörpers 5 ist ein kegelstumpfförmiger Bereich angeordnet, der mit einem transparenten Kunststoffkleber bei der Montage der digitalen Kamera 1 aufgefüllt wird, so dass der gesamte Strahlengang in der digitalen Kamera 1 durch einen transparenten Kunststoff geführt wird.

Der in der Figur 4c dargestellte Kunststoffkörper wird aus einer Kunststoffplatte herausgetrennt, die eine Vielzahl von Kunststoffkörpern 5 für digitale Kameras 1 aufweist. Diese Platte mit einer Dicke zwischen 2 und 3 mm kann mittels eines Spritzgussverfahrens in einer zweiteiligen Form hergestellt werden, dessen Kavitäten so ausgebildet sind, dass sie die Öffnungen 49 und 50 sowie die kegelstumpfförmige Verbindung für einen transparenten Kunststoffkern 35 automatisch beim Einspritzen des lichtundurchlässigen Kunststoffs herstellt.

Figur 4d zeigt einen Halbleitersensor, der auf seiner Unterseite eine Umverdrahtungsstruktur 11 mit Außenanschlüssen 13 in Form von Kontakthöckern trägt, die auf entsprechende Kontaktanschlussflächen der Umverdrahtungsfolie aufgelötet sind. Derartige Halbleitersensoren 9 können in einer Vielzahl in Siliciumplanartechnologie auf einem Siliciumwafer hergestellt werden, der anschließend zu Halbleitersensoren aufgetrennt wird und mit einer entsprechenden Umverdrahtungsstruktur versehen wird.

Figur 4e zeigt eine Draufsicht auf die zusammengebaute digitale Kamera. Dazu sind lediglich die Komponenten der Figuren 4a bis 4d über einen Optik-UV-Kitt miteinander zu verkleben. Diese Montage kann aber auch direkt nach dem Spritzgießen einer Vielzahl von Kunststoffkörpern 5 in einer Kunststoffplatte erfolgen.

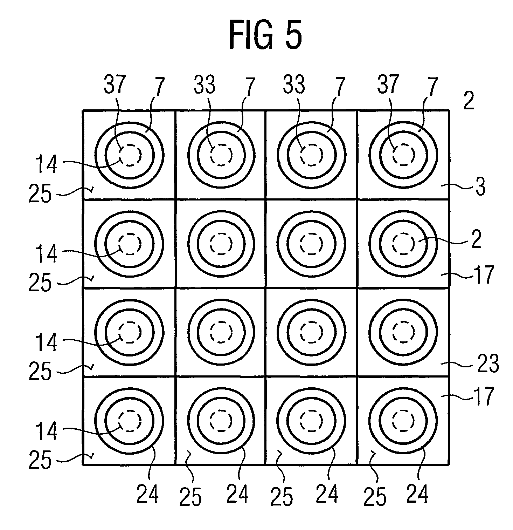

Figur 5 zeigt schematisch eine Draufsicht auf eine plattenförmige Anordnung von mehreren Linsen 2 für digitale Kameras einer Ausführungsform der vorliegenden Erfindung. In dieser Ausführungsform werden entsprechende Öffnungen 24 in eine Kunststoffplatte für mehrere digitale Kameras gleichzeitig eingebracht und diese Öffnungen 24 mit den einzelnen Komponenten, wie sie Figur 4 zeigt, bestückt. Erst danach wird dann die Platte zu einzelnen digitalen Kameras, beispielsweise durch Sägetechnik, aufgetrennt. Dabei werden mehrere Verfahrensschritte nacheinander durchgeführt.

Zunächst wird eine Spritzgussform, die mindestens eine Kavität zum Spritzgießen einer Kunststoffplatte 23 für mehrere Kameragehäuse 3 einer digitalen Kamera 1 aufweist, bereitgestellt. Dazu weist die Kunststoffplatte 23 passende Öffnungen auf ihrer Oberseite 25 zur Aufnahme von Linsen 2 und auf ihrer Unterseite zur Aufnahme eines Halbleitersensors auf. Zunächst wird diese Kunststoffplatte 23 auf ihrer Unterseite mit Halbleitersensoren, die eine Umverdrahtungsstruktur und Außenanschlüssen tragen, bestückt. Danach wird der Kunststoffkern des Kunststoffkörpers mit transparentem Klebstoff wie einem UV-aushärtbaren Optik-UV-Kitt aufgefüllt. Schließlich werden von der Oberseite 25 aus Linsen 2 in die dafür vorgesehenen Öffnungen eingebracht. Abschließend kann zur Fertigstellung der Kunststoffplatte mit mehreren digitalen Kameras eine Lichtschutzmaske unter Freilassung jeder Linse auf der Oberseite 25 der Kunststoffplatte 23 aufgebracht werden.

Das Aufbringen der Lichtschutzmaske 7 kann auch durch eine Mehrzahl von scheibenförmigen Lichtschutzmasken auf jeder der digitalen Kameras der Kunststoffplatte 23 erfolgen. Zum Abschluss wird die Kunststoffplatte 23 in einzelne digitale Kameras getrennt.

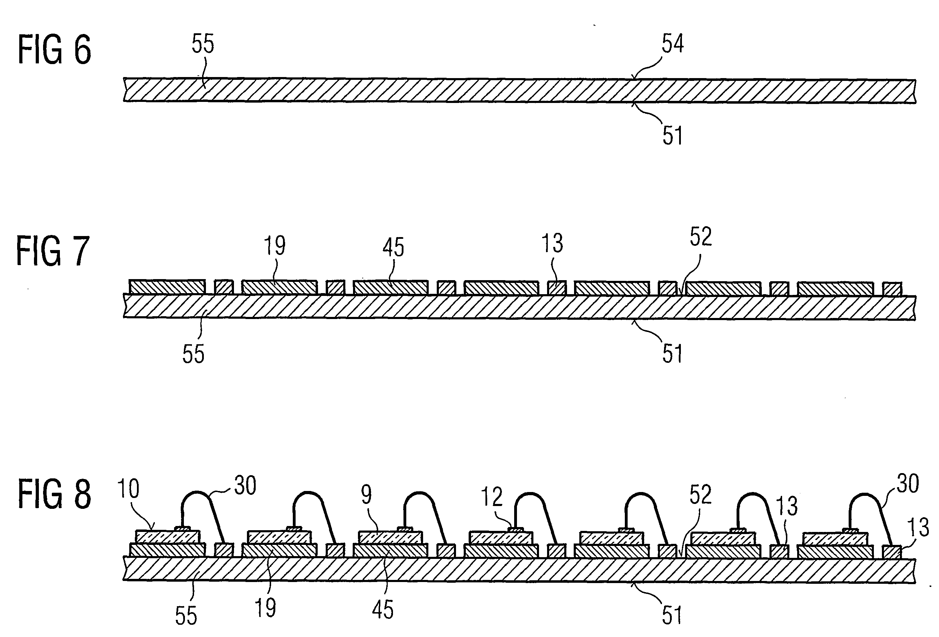

Die Figuren 6 bis 14 zeigen die Herstellung einer elektronischen Kamera, wie sie in Figur 3 gezeigt wird.

Figur 6 zeigt einen schematischen Querschnitt eines Trägersubstrats 55, auf dem ein Systemträger galvanisch abgeschieden werden kann. Dieses Trägersubstrat 55 ist deshalb aus einem Metall, vorzugsweise aus einer Kupferlegierung, die eine gute elektrische Leitfähigkeit im Galvanikbad aufweist. Die Unterseite 51 des Trägersubstrats 55 wird vollständig mit einer organischen Isolierschicht abgedeckt, während die Oberseite 52 des Trägersubstrats mit einer selektiv strukturierten organischen Abdeckschicht abgedeckt wird. Diese nichtgezeigte selektiv strukturierte Abdeckschicht lässt die Oberseite 52 an den Stellen frei, an denen Material für einen Systemträger galvanisch abgeschieden werden soll.

Figur 7 zeigt einen schematischen Querschnitt eines Trägersubstrats 55 mit darauf abgeschiedenen Komponenten eines Systemträgers 19. Im wesentlichen bestehen diese Komponenten aus einer Kontaktplatte 45 für jede digitale Kamera und einer entsprechenden Anzahl von Außenanschlüssen 13. Diese Komponenten können beispielsweise als Nickellegierung in dem galvanischen Bad auf der Oberseite 52 des Trägersubstrats 55 abgeschieden werden. Zur Veredelung der Oberfläche 56 mit einer bondbaren Beschichtung können auf dieser Oberfläche 56 Edelmetalle wie Gold oder Silber oder auch Aluminium abgeschieden werden. Dabei kann durch Überwachsen der Oberfläche 56 mit dieser Beschichtung gleichzeitig ein Überkragen der Beschichtung über die Ränder der vorgesehenen Systemträgerstrukturen erreicht werden, so dass die Kontaktplatte 45 und die Außenanschlüsse 13 in dem transparenten Kunststoffblock der digitalen Kamera formschlüssig verankert werden können.

Figur 8 zeigt einen schematischen Querschnitt eines Systemträgers 19 mit darauf angeordnetem Halbleitersensor 9 und Bonddrahtverbindungen 30 zu den Außenanschlüssen 13. Dazu wird auf jeder Kontaktplatte 45 zunächst mit Leitkleber oder durch thermisches Einlegieren ein Halbleitersensor, beispielsweise aus Silicium, montiert. Danach kann mit Hilfe eines Bondverfahrens ein Leitungsdraht auf die Kontaktflächen 12 auf der Oberseite des Halbleitersensors 9 gebondet werden und mit den Außenanschlüssen 13 verbunden werden.

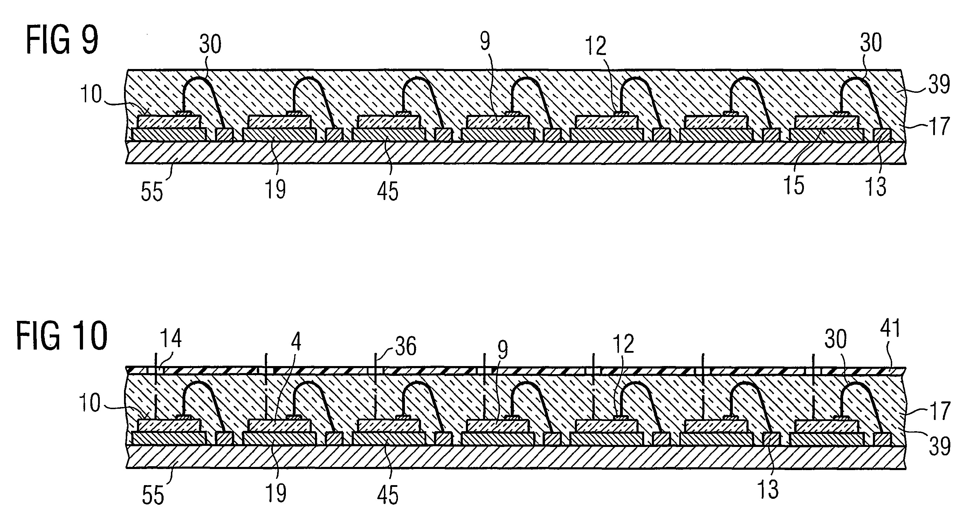

Figur 9 zeigt einen schematischen Querschnitt einer unteren transparenten Kunststoffplattenhälfte 39 für mehrere digitale Kameras. Diese Kunststoffplattenhälfte 39 kann durch ein Spritzgießen auf dem Trägersubstrat erfolgen, so dass der gesamte Systemträger 19 mit den Halbleitersensoren 9 und den Außenanschlüssen 13 sowie den Verbindungen 30 in transparentem Kunststoff mittels eines Spritzgussverfahres eingebettet werden. Auf diese untere transparente Kunststoffplattenhälfte 39 wird in einem nachfolgenden Schritt eine Lochblende aufgebracht.

Figur 10 zeigt in schematischem Querschnitt das Aufbringen einer Lochblendenschicht 41 auf die untere transparente Kunststoffplattenhälfte 39. Dabei werden die Aperturen 14 der Lochblendenschicht 41 mit den Zentren 36 der digitalen Kamera ausgerichtet. Diese Lochblendenbeschichtung kann durch Aufbringen eines lichtundurchlässigen Kunststoffes erfolgen, der entweder anschließend durch eine Photolithographietechnik strukturiert wird oder durch eine Maske so aufgebracht wird, dass dabei die Lochblendenöffnungen von lichtundurchlässigem Kunststoff freigehalten werden.

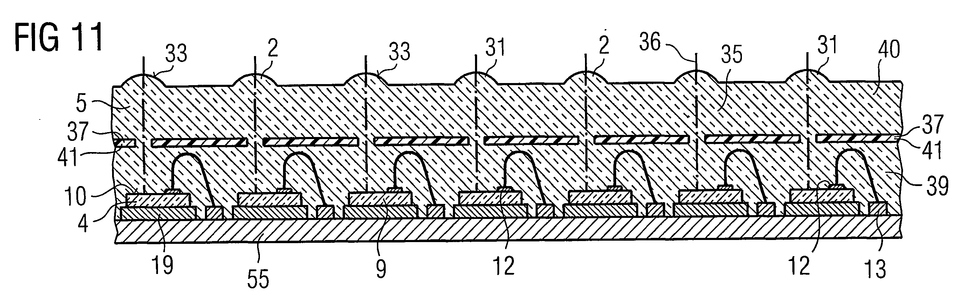

Figur 11 zeigt in einem schematischen Querschnitt das Aufbringen einer oberen transparenten Kunststoffplattenhälfte 40 auf die Lochblendenschicht 41, wobei die obere transparente Kunststoffplattenhälfte 40 angeformte Linsen 2 auf der Oberseite der oberen transparenten Kunststoffplattenhälfte 40 aufweist. Auch dieses Aufbringen kann durch einen einzigen Spritzgussvorgang erfolgen, so dass für eine Vielzahl von digitalen Kameras ein Block aus homogenem transparenten Kunststoff entsteht, der eine integrale Linse 2 in Form von Auswölbungen 31 auf der Oberseite der aufgebrachten transparenten Kunststoffplattenhälfte 40 aufweist. Die ganze Struktur wird in Figur 11 noch von dem Trägersubstrat 55 zusammengehalten und getragen.

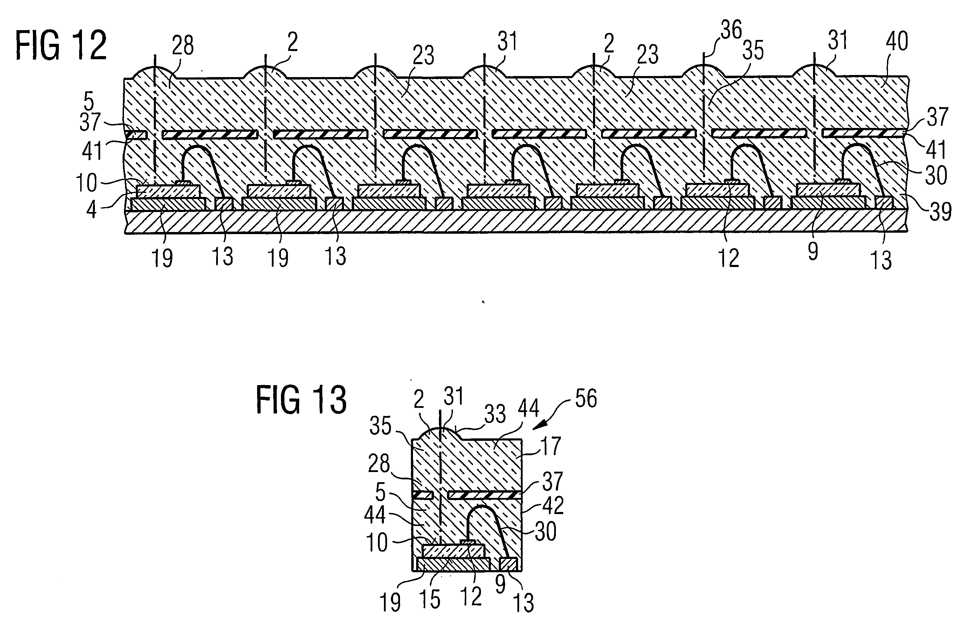

Figur 12 zeigt einen schematischen Querschnitt der Figur 11 nach Abätzen des Trägersubstrats 55. Das Abätzen des Trägersubstrats 55 wird dadurch erleichtert, dass einerseits ein Materialunterschied zwischen dem Trägersubstrat 55 und dem Metall des Systemträgers 19 besteht, so dass der Abätzvorgang des Trägersubstrats 55 an der Grenzfläche zum Trägersubstrat weitestgehend gestoppt wird. Nach dem Abtrennen des Trägersubstrats 55 kann die transparente Kunststoffplatte 23 zu einzelnen transparenten digitalen Kameras 56 aufgetrennt werden.

Figur 13 zeigt eine aus der transparenten Kunststoffplatte 23 der Figur 12 herausgetrennte transparente digitale Kamera 56. Komponenten, die gleiche Funktionen wie in den vorhergehenden Figuren aufweisen, werden mit gleichen Bezugszeichen gekennzeichnet und nicht extra erläutert. Diese transparente digitale Kamera 56 hat den Nachteil, dass sie über ihre transparenten Seiten und Oberflächen derart viel Streulicht einfängt, dass das Bild völlig verrauscht wäre. Jedoch kann diese transparente elektronische Kamera 56 aus einem transparenten Kunststoffblock 44 in eine lichtundurchlässige Fassung eines Gerätes eingesetzt werden, ohne dass vorher die transparenten Seitenflächen durch eine lichtundurchlässige Schicht oder durch ein lichtundurchlässiges Spezialgehäuse geschützt werden.

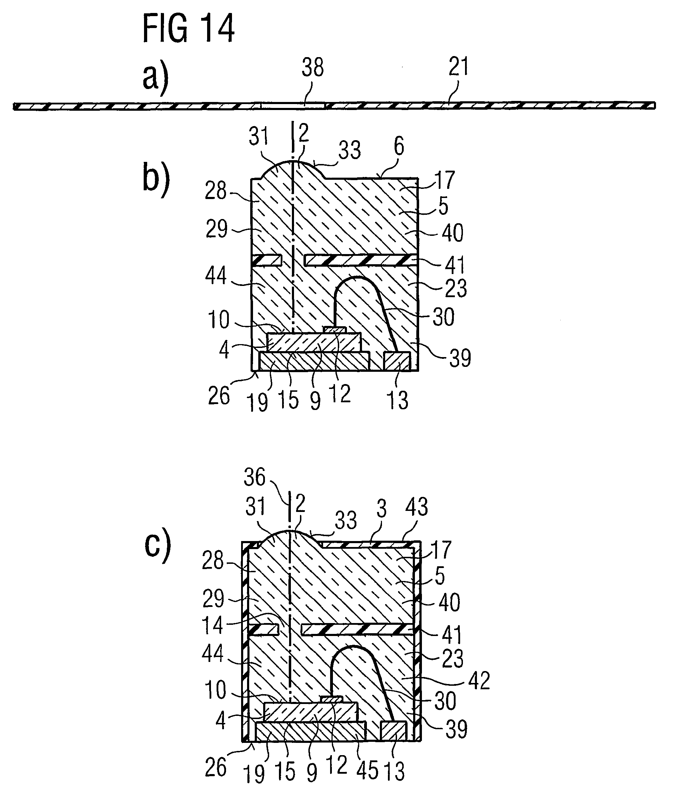

Figur 14 zeigt mit den Unterfiguren a) bis c) Herstellungsschritte in schematischen Querschnitten einer transparenten digitalen Kamera 1 der Ausführungsform nach Figur 3.

Mit Figur 14a wird eine Schrumpffolie 21 schematisch im Querschnitt dargestellt, die eine Öffnung 38 aufweist, die der Größe und dem Umfang einer Linse 2 der transparenten elektronischen Kamera 56, wie sie in Figur 13 gezeigt wird, entspricht.

Figur 14b zeigt eine auf die Öffnung 38 in Figur 14a ausgerichtete transparente Kamera, wie sie aus den Figuren 3 und 13 bekannt ist. Komponenten mit gleichen Funktionen wie in den vorhergehenden Figuren werden mit gleichen Bezugszeichen gekennzeichnet und nicht extra erläutert. Durch Erwärmen der in Figur 14a dargestellten Schrumpffolie 21 nach dem Auflegen der Schrumpffolie auf die Oberseite 6 des Kunststoffkörpers wird die Schrumpffolie 21 erhitzt und legt sich als lichtundurchlässiges Gehäuse an die Oberflächen des transparenten Kunststoffblockes 44 der transparenten digitalen Kamera 56 an.

Fig. 14c zeigt das Ergebnis dieses Verfahrensschrittes, das im wesentlichen eine digitale Kamera der dritten Ausführungsform, wie sie in Figur 3 gezeigt wird, der vorliegenden Erfindung im schematischen Querschnitt zeigt. Dabei ist der transparente Kunststoff entweder ein PMMA oder ein Polycarbonat und die Brennweite der Linse ist in dieser Ausführungsform auf 1,3 mm eingestellt. Die Öffnung ist bei einem Objektfeld von 20° auf 1 : 2,5 eingestellt und die Aperturblende hat eine Öffnung mit einem Durchmesser zwischen 0,25 mm und 0,45 mm, während die aktive Fläche des Halbleitersensors 9 einen Durchmesser von 0,40 mm bis 0,9 mm aufweist. Die Aperturblende ist in dieser Ausführungsform der Erfindung in einem Abstand von der Vorderseite der Linse von 0,5 bis 0,9 mm eingearbeitet und die Entfernung zwischen der Oberseite der Linse und der Oberseite 10 des Halbleitersensors 9 liegt bei dieser Ausführungsform zwischen 1,5 mm und 3 mm.

Der Systemträger 19 mit der Kontaktplatte 45 und den Außenanschlüssen 13 ist in dieser Ausführungsform aus einer Nickellegierung, während der Bonddraht 30 aus einem Gold- oder Aluminiumdraht hergestellt ist. Der Halbleitersensor 9 mit seinen integrierten Schaltungen besteht aus einem Siliciumplanarchip, während die Lochblendenschicht 41 aus einem mit einem lichtabsorbierenden Pulver gefüllten transparenten Kunststoff der gleichen Art wie der transparente Kunststoffblock 44 der digitalen Kamera besteht. Die Linse kann sphärisch gekrümmt sein oder auch schwach asphärisch elliptisch deformiert sein mit einer Kegelschnittkonstanten k = -0,2. Mit dieser digitalen Kamera sind Objektivfelder zwischen 20 und 30° bei einer Pixeldichte von 128 x 128 bei einer Pixelgröße von 2,5 µm und einer Bilddiagonalen von 0,45 mm möglich. Mit einem Halbleitersensor einer Pixelfläche von 256 x 256 Pixel bei einer Pixelgröße von 2,5 µm sind eine Bilddiagonale von 0,9 mm vorgesehen. Der Öffnungs- oder Feldwinkel von jeweils 20 bis 30° ist dabei für Personenaufnahmen bereits mit einem leichten Teleeffekt verbunden. Je stärker das Gehäuse der Kamera minimiert wird, desto kostengünstiger werden zwar der Aufbau für Gehäuse und Halbleitersensor, jedoch nimmt gleichzeitig die Bildquälität ab.

## Patentansprüche

1. Digitale Kamera mit einer Linse (2), die eine Linsenoberseite (33) und eine Linsenunterseite (34) aufweist, einem Kameragehäuse (3) und einem lichtempfindlichen Sensor (4), der eine zur Linse (2) ausgerichtete Oberseite (10) und eine Unterseite (15) aufweist, wobei das Kameragehäuse (3) einen Kunststoffkörper (5) aufweist, der auf seiner Oberseite (6) die Linse (2) trägt und auf seiner Unterseite (8) als lichtempfindlichen Sensor (4) einen Halbleitersensor (9) aufweist, wobei die Kamera (1) einen transparenten Kunststoffkern (35) aufweist, der mindestens einen Zwischenraum zwischen der Linsenunterseite (34) und der Oberseite (10) des Halbleitersensors (9) ausfüllt, und wobei eine kreisförmige Apertur (14) zwischen Linsenunterseite (34) und Oberseite (10) des Halbleitersensors (9) in dem transparenten Kunststoffkern (35) angeordnet ist, wobei der transparente Kunststoffkörper (5) von einer Lichtschutzfolie (7) unter Freilassung einer Öffnung (38) für die Linse (2) bedeckt ist, und, **dadurch gekennzeichnet daß** die Lichtschutzfolie (7) eine Schrumpffolie ist.

2. Digitale Kamera nach Anspruch 1,
**dadurch gekennzeichnet, dass**
der Halbleitersensor (9) auf seiner Oberseite (10) eine Matrix von lichtempfindlichen Zellen aufweist, deren Elektroden über integrierte Schaltungen mit Kontaktflächen (12) verbunden sind, die mit einer Umverdrahtungsstruktur (11) auf der Unterseite des Kameragehäuses (3) und den dort angeordneten Außenanschlüssen (13) zusammenwirken.

3. Digitale Kamera nach Anspruch 1 oder Anspruch 2,
**dadurch gekennzeichnet, dass**
der Kunststoffkörper (5) lichtabsorbierendes Material und einen kegelstumpfförmigen transparenten Kunststoffkern (35) in seinem Zentrum (36) umgibt.

4. Digitale Kamera nach einem der vorhergehenden Ansprüche,
**dadurch gekennzeichnet, dass**
der Kunststoffkörper (5) selbst lichttransparentes Material aufweist.

5. Digitale Kamera nach einem der vorhergehenden Ansprüche,
**dadurch gekennzeichnet, dass**
die Apertur (14) eine Lochblende (37) aufweist, die in einem Abstand von der Linsenoberseite (33) angeordnet ist, wobei der Abstand zwischen einer Hälfte und einem Drittel des Abstandes zwischen Linsenoberseite (33) und der Oberseite (10) des Halbleitersensors (9) ist.

6. Digitale Kamera nach einem der vorhergehenden Ansprüche,
**dadurch gekennzeichnet, dass**
die Umverdrahtungsstruktur (11) auf der Unterseite (8) des Kunststoffkörpers (5) angeordnet ist.

7. Digitale Kamera nach einem der Ansprüche 1 bis 6,
**dadurch gekennzeichnet, dass**
die Umverdrahtungsstruktur (11) auf der Unterseite (15) des Halbleitersensors (9) angeordnet ist.

8. Digitale Kamera nach einem der vorhergehenden Ansprüche,
**dadurch gekennzeichnet, dass**
die Umverdrahtungsstruktur (11) ein Systemträger (19) ist, auf dem der Halbleitersensor (9) montiert ist.

9. Digitale Kamera nach einem der vorhergehenden Ansprüche,
**dadurch gekennzeichnet, dass**
die Linse (2) von einer Lichtschutzmaske (7) umgeben ist.

10. Digitale Kamera nach einem der vorhergehenden Ansprüche
**dadurch gekennzeichnet, dass**
die Umverdrahtungsstruktur (11) Leiterbahnen aufweist, welche die Kontaktflächen (12) des Halbleitersensors (9) mit Außenanschlüssen (13) auf der Unterseite der Digital-Kamera (1) verbindet.

11. Digitale Kamera nach einem der vorhergehenden Ansprüche
**dadurch gekennzeichnet, dass**
die Außenanschlüsse (13) Kontakthöcker aufweisen.

12. Digitale Kamera nach einem der vorhergehenden Ansprüche
**dadurch gekennzeichnet, dass**
die digitale Kamera (1) als Umverdrahtungsstruktur (11) einen Systemträger (19) aufweist, der den Halbleitersensor (9) trägt und elektrischen Außenanschlüssen (13) aufweist, wobei die Kontaktflächen (12) des Halbleitersensors (9) über Bondverbindungen (30) mit den Außenanschlüssen (13) verbunden sind.

13. Digitale Kamera nach einem der vorhergehenden Ansprüche
**dadurch gekennzeichnet, dass**
die digitale Kamera (1) einen Kunststoffkörper (5) aufweist, der mit der Linse (2) einen gemeinsamen Kunststoffkörper (5) aus transparentem Kunststoff aufweist.

14. Digitale Kamera nach einem der in der Ansprüche 8 bis 13,
**dadurch gekennzeichnet, dass**
der Halbleitersensor (9) auf dem Systemträger (19) mit einem Klebstoff (22), vorzugsweise einem Leitkleber montiert ist.

15. Digitale Kamera nach einem der vorhergehenden Ansprüche,
**dadurch gekennzeichnet, dass**
der Halbleitersensor (9) mittels eines Klebstoffs (22) auf der Unterseite (8) des Kunststoffkörpers (5) montiert ist.

16. Digitale Kamera nach einem der vorhergehenden Ansprüche,
**dadurch gekennzeichnet, dass**
die Linse (2) mit einem Klebstoff (22) auf dem Kunststoff Körper (5) montiert ist.

17. Digitale Kamera nach einem der Ansprüche 11 bis 16,
**dadurch gekennzeichnet, dass**
die Außenkontakthöcker auf der Unterseite (15) des Halbleitersensors (9) mittels Lotmaterial montiert sind.

18. Digitale Kamera nach einem der Ansprüche 11 bis 17,
**dadurch gekennzeichnet, dass**
die Außenkontakthöcker Lotmaterial aufweisen.

19. Digitale Kamera mit einer Linse (2), die eine Linsenoberseite (33) und eine Linsenunterseite (34) aufweist, einem Kameragehäuse (3) und einem lichtempfindlichen Sensor (4), der eine zur Linse (2) ausgerichtete Oberseite (10) und eine Unterseite (15) aufweist, wobei das Kameragehäuse (3) einen Kunststoffkörper (5) aufweist, der auf seiner Oberseite (6) die Linse (2) trägt und auf seiner Unterseite (8) als lichtempfindlichen Sensor (4) einen Halbleitersensor (9) aufweist, wobei die Kamera (1) einen transparenten Kunststoffkern (35) aufweist, der mindestens einen Zwischenraum zwischen der Linsenunterseite (34) und der Oberseite (10) des Halbleitersensors (9) ausfüllt, und wobei eine kreisförmige Apertur (14) zwischen Linsenunterseite (34) und Oberseite (10) des Halbleitersensors (9) in dem transparenten Kunststoffkern (35) angeordnet ist, **dadurch gekennzeichnet da**ß der Kunststoffkörper (5) lichtabsorbierendes Material und einen kegelstumpfförmigen transparenten Kunststoffkern (35) in seinem Zentrum (36) umgibt.

20. Digitale Kamera nach Anspruch 19,
**dadurch gekennzeichnet, dass**
der Halbleitersensor (9) auf seiner Oberseite (10) eine Matrix von lichtempfindlichen Zellen aufweist, deren Elektroden über integrierte Schaltungen mit Kontaktflächen (12) verbunden sind, die mit einer Umverdrahtungsstruktur (11) auf der Unterseite des Kameragehäuses (3) und den dort angeordneten Außenanschlüssen (13) zusammenwirken.

21. Digitale Kamera nach Anspruch 19 oder 20,
**dadurch gekennzeichnet, dass**
der Kunststoffkörper (5) selbst lichttransparentes Material aufweist.

22. Digitale Kamera nach einem der Ansprüche 19 bis 21,
**dadurch gekennzeichnet, dass**
die Apertur (14) eine Lochblende (37) aufweist, die in einem Abstand von der Linsenoberseite (33) angeordnet ist, wobei der Abstand zwischen einer Hälfte und einem Drittel des Abstandes zwischen Linsenoberseite (33) und der Oberseite (10) des Halbleitersensors (9) ist.

23. Digitale Kamera nach einem der Ansprüche 19 bis 22,
**dadurch gekennzeichnet, dass**
die Umverdrahtungsstruktur (11) auf der Unterseite (8) des Kunststoffkörpers (5) angeordnet ist.

24. Digitale Kamera nach einem der Ansprüche 19 bis 23,
**dadurch gekennzeichnet, dass**
die Umverdrahtungsstruktur (11) auf der Unterseite (15) des Halbleitersensors (9) angeordnet ist.

25. Digitale Kamera nach einem der Ansprüche 19 bis 24,
**dadurch gekennzeichnet, dass**
die Umverdrahtungsstruktur (11) ein Systemträger (19) ist, auf dem der Halbleitersensor (9) montiert ist.

26. Digitale Kamera nach einem der Ansprüche19 bis 25,
**dadurch gekennzeichnet, dass**
die Linse (2) von einer Lichtschutzmaske (7) umgeben ist.

27. Digitale Kamera nach einem der Ansprüche 19 bis 26,
**dadurch gekennzeichnet, dass**
die Umverdrahtungsstruktur (11) Leiterbahnen aufweist, welche die Kontaktflächen (12) des Halbleitersensors (9) mit Außenanschlüssen (13) auf der Unterseite der Digital-Kamera (1) verbindet.

28. Digitale Kamera nach einem der Ansprüche 19 bis 27,
**dadurch gekennzeichnet, dass**
die Außenanschlüsse (13) Kontakthöcker aufweisen.

29. Digitale Kamera nach einem der Ansprüche 19 bis 28,
**dadurch gekennzeichnet, dass**
die digitale Kamera (1) als Umverdrahtungsstruktur (11) einen Systemträger (19) aufweist, der den Halbleitersensor (9) trägt und elektrischen Außenanschlüssen (13) aufweist, wobei die Kontaktflächen (12) des Halbleitersensors (9) über Bondverbindungen (30) mit den Außenanschlüssen (13) verbunden sind.

30. Digitale Kamera nach einem der Ansprüche 19 bis 29,
**dadurch gekennzeichnet, dass**
die digitale Kamera (1) einen Kunststoffkörper (5) aufweist, der mit der Linse (2) einen gemeinsamen Kunststoffkörper (5) aus transparentem Kunststoff aufweist.

31. Digitale Kamera nach einem der Ansprüche 19 bis 30,
**dadurch gekennzeichnet, dass**
der transparente Kunststoffkörper (5) von einer Lichtschutzfolie (18) unter Freilassung einer Öffnung (38) für die Linse (2) bedeckt ist.

32. Digitale Kamera nach einem der in der Ansprüche 25 bis 31,
**dadurch gekennzeichnet, dass**
der Halbleitersensor (9) auf dem Systemträger (19) mit einem Klebstoff (22), vorzugsweise einem Leitkleber montiert ist.

33. Digitale Kamera nach einem der Ansprüche 19 bis 32,
**dadurch gekennzeichnet, dass**
der Halbleitersensor (9) mittels eines Klebstoffs (22) auf der Unterseite (8) des Kunststoffkörpers (5) montiert ist.

34. Digitale Kamera nach einem der Ansprüche 19 bis 33,
**dadurch gekennzeichnet, dass**
die Linse (2) mit einem Klebstoff (22) auf dem Kunststoff Körper (5) montiert ist.

35. Digitale Kamera nach einem der Ansprüche 28 bis 34,
**dadurch gekennzeichnet, dass**
die Außenkontakthöcker auf der Unterseite (15) des Halbleitersensors (9) mittels Lotmaterial montiert sind.

36. Digitale Kamera nach einem der Ansprüche 28 bis 35,
**dadurch gekennzeichnet, dass**
die Außenkontakthöcker Lotmaterial aufweisen.

37. Verfahren zur Herstellung einer digitalen Kamera nach Anspruch 19, das folgende Verfahrensschritte aufweist:
- Bereitstellen einer Spritzgussform, die mindestens eine Kavität zum Spritzgießen einer Kunststoffplatte (23) für mehrere Kameragehäuse (3) einer digitalen Kamera (1) aufweist, wobei die Kunststoffplatte (23) passende Öffnungen auf ihrer Oberseite (25) zur Aufnahme einer Linse (2) und auf ihrer Unterseite (26) zur Aufnahme eines Halbleitersensors (9) aufweist,
- Bestücken der Unterseite (26) der Kunststoffplatte (23) mit Halbleitersensoren (9), Umverdrahtungsstrukturen (11) und Außenanschlüssen (13),
- Auffüllen des Kunststoffkerns (35) des Kunststoffkörpers (5) mit transparentem Klebstoff, wobei der Kunststoffkörper (5) lich absorbierendes Material und einen kegelstumpfförmigen transparenten Kunststoffkern (35) in seinem Zentrum (36) umgibt,
- Bestücken der Oberseite (25) der Kunststoffplatte (23) mit Linsen (2) in den dafür vorgesehenen Öffnungen, wobei das Bestücken der Unterseite (26) der Kunststoffplatte (23) mit Halbleitersensoren (9), die Außenkontakthöcker aufweisen, mittels Flip-Chip-Technologie in die dafür vorgesehenen Öffnungen erfolgt.
- Aufbringen einer Lichtschutzmaske (7) unter Freilassung jeder Linse (2) auf der Oberseite (25) der Kunststoffplatte (23),
- Trennen der Kunststoffplatte (23) in einzelne digitale Kameras (1).

38. Verfahren nach Anspruch 37,
**dadurch gekennzeichnet, dass**
das Auffüllen eines kegelstumpfförmigen Kunststoffkerns (35) unter Vakuum durchgeführt wird

39. Verfahren zur Herstellung einer digitalen Kamera nach Anspruch 1, das folgende Verfahrensschritte aufweist:
- Bereitstellen eines Systemträgers (19) für mehrere Halbleitersensoren (9) und mit Flachleitern für Außenanschlüsse,
- Aufbringen von Halbleitersensoren (9) auf den Systemträger,
- Verbinden von Kontaktflächen (12) auf der Oberseite des Halbleitersensors (9) mit den Außenanschlüssen (13),
- Vergießen des Systemträgers (19) mit einem transparenten Kunststoff zu einer transparenten unteren Kunststoffplattenhälfte (39) unter Einbetten des Systemträgers (19), der Außenanschlüsse (13) und der Verbindungen (30) auf der Unterseite (26) der Kunststoffplatte (30),
- selektives Beschichten der Oberseite der unteren Kunststoffplattenhälfte (39) mit einer Lochblendenschicht (41),
- Aufbringen einer oberen transparenten mit domartigen Auswölbungen (31) auf der Oberseite versehenen Kunststoffplattenhälfte (40) auf die Lochblendenschicht (41),
- Trennen der Kunststoffplatte in einzelne transparente digitale Kameras (56) mit integraler Linse (2) und eingebautem Halbleitersensor (9) sowie mit Außenanschlüssen (13).
- Aufbringen einer Lichtschutzfolie (32) unter Freilassung einer Öffnung für die Linse (2) und von Öffnungen für die Außenanschlüsse auf den Außenseiten (42,43, 44) der transparenten digitalen Kamera (56), wobei die Lichtschutzfolie (32) eine Schrumpffolie ist, die als Kameragehäuse (3) auf die Außenseiten der transparenten digitalen Kamera (56) aufgeschrumpft wird.

## Claims

1. Digital camera with a lens (2) that has a lens top side (33) and a lens underside (34), and with a camera housing (3) and a light-sensitive sensor (4) that has a top side (10), directed to the lens (2), and an underside (15), in which the camera housing (3) has a plastic body (5) that bears the lens (2) on its top side (6) and has a semiconductor sensor (9) as light-sensitive sensor (4) on its underside (8), in which the camera (1) has a transparent plastic core (35) that fills up at least one interspace between the lens underside (34) and the top side (10) of the semiconductor sensor (9) and in which a circular aperture (14) is arranged between the lens underside (34) and the top side (10) of the semiconductor sensor (9) in the transparent plastic core (35), the transparent plastic body (5) being covered by a lightsafe film (7), while leaving free an opening (38) for the lens (2) and **characterized in that** the lightsafe film (7) is a shrink film.

2. Digital camera according to Claim 1, **characterized in that** the semiconductor sensor (9) has on its top side (10) a matrix of light-sensitive cells whose electrodes are connected via integrated circuits to contact surfaces (12) that cooperate with a rewiring structure (11) on the underside of the camera housing (3) and the external connections (13) arranged there.

3. Digital camera according to Claim 1 or Claim 2, **characterized in that** the plastic body (5) has light-absorbing material and surrounds a frustoconical transparent plastic core (35) at its centre (36).

4. Digital camera according to one of the preceding claims, **characterized in that** the plastic body (5) itself has optically transparent material.

5. Digital camera according to one of the preceding claims, **characterized in that** the aperture (14) has an aperture plate (37) that is arranged at a distance from the lens top side (33), the distance being between a half and a third of the distance between the lens top side (33) and the top side (10) of the semiconductor sensor (9).

6. Digital camera according to one of the preceding claims, **characterized in that** the rewiring structure (11) is arranged on the underside (8) of the plastic body (5).

7. Digital camera according to one of Claims 1 to 6, **characterized in that** the rewiring structure (11) is arranged on the underside (15) of the semiconductor sensor (9).

8. Digital camera according to one of the preceding claims, **characterized in that** the rewiring structure (11) is a system carrier (19) on which the semiconductor sensor (9) is mounted.

9. Digital camera according to one of the preceding claims, **characterized in that** the lens (2) is surrounded by a lightsafe mask (7).

10. Digital camera according to one of the preceding claims, **characterized in that** the rewiring structure (11) has conductor tracks that connect the contact surfaces (12) of the semiconductor sensor (9) to external connections (13) on the underside of the digital camera (1).

11. Digital camera according to one of the preceding claims, **characterized in that** the external connections (13) have contact bumps.

12. Digital camera according to one of the preceding claims, **characterized in that** the digital camera (1) has as rewiring structure (11) a system carrier (19) that bears the semiconductor sensor (9) and has external electric connections (13), the contact surfaces (12) of the semiconductor sensor (9) being connected to the external connections (13) via bonded connections (30).

13. Digital camera according to one of the preceding claims, **characterized in that** the digital camera (1) has a plastic body (5) that has a common plastic body (5) made from transparent plastic with the lens (2).

14. Digital camera according to one of Claims 8 to 13, **characterized in that** the semiconductor sensor (9) is mounted on the system carrier (19) with the aid of an adhesive (22), preferably a conductive adhesive.

15. Digital camera according to one of the preceding claims, **characterized in that** the semiconductor sensor (9) is mounted on the underside (8) of the plastic body (5) by means of an adhesive (22).

16. Digital camera according to one of the preceding claims, **characterized in that** the lens (2) is mounted on the plastic body (5) with the aid of an adhesive (22).

17. Digital camera according to one of Claims 11 to 16, **characterized in that** the external contact bumps are mounted on the underside (15) of the semiconductor sensor (9) by means of soldering material.

18. Digital camera according to one of Claims 11 to 17, **characterized in that** the external contact bumps have soldering material.

19. Digital camera with a lens (2) that has a lens top side (33) and a lens underside (34), and with a camera housing (3) and a light-sensitive sensor (4) that has a top side (10), directed to the lens (2), and an underside (15), in which the camera housing (3) has a plastic body (5) that bears the lens (2) on its top side (6) and has a semiconductor sensor (9) as light-sensitive sensor (4) on its underside (8), in which the camera (1) has a transparent plastic core (35) that fills up at least one interspace between the lens underside (34) and the top side (10) of the semiconductor sensor (9) and in which a circular aperture (14) is arranged between the lens underside (34) and the top side (10) of the semiconductor sensor (9) in the transparent plastic core (35), **characterized in that** the plastic body (5) has light-absorbing material and surrounds a frustoconical transparent plastic core (35) at its centre (36).

20. Digital camera according to Claim 19, **characterized in that** the semiconductor sensor (9) has on its top side (10) a matrix of light-sensitive cells whose electrodes are connected via integrated circuits to contact surfaces (12) that cooperate with a rewiring structure (11) on the underside of the camera housing (3) and the external connections (13) arranged there.

21. Digital camera according to Claim 19 or 20, **characterized in that** the plastic body (5) itself has optically transparent material.

22. Digital camera according to one of Claims 19 to 21, **characterized in that** the aperture (14) has an aperture plate (37) that is arranged at a distance from the lens top side (33), the distance being between a half and a third of the distance between the lens top side (33) and the top side (10) of the semiconductor sensor (9).

23. Digital camera according to Claim 19 to 22, **characterized in that** the rewiring structure (11) is arranged on the underside (8) of the plastic body (5).

24. Digital camera according to one of Claims 19 to 23, **characterized in that** the rewiring structure (11) is arranged on the underside (15) of the semiconductor sensor (9).

25. Digital camera according to one of Claims 19 to 24, **characterized in that** the rewiring structure (11) is a system carrier (19) on which the semiconductor sensor (9) is mounted.

26. Digital camera according to one of Claims 19 to 25, **characterized in that** the lens (2) is surrounded by a lightsafe mask (7).

27. Digital camera according to one of Claims 19 to 26, **characterized in that** the rewiring structure (11) has conductor tracks that connect the contact surfaces (12) of the semiconductor sensor (9) to external connections (13) on the underside of the digital camera (1).

28. Digital camera according to one of Claims 19 to 27, **characterized in that** the external connections (13) have contact bumps.

29. Digital camera according to one of Claims 19 to 28, **characterized in that** the digital camera (1) has as rewiring structure (11) a system carrier (19) that bears the semiconductor sensor (9) and has external electric connections (13), the contact surfaces (12) of the semiconductor sensor (9) being connected to the external connections (13) via bonded connections (30).

30. Digital camera according to one of Claims 19 to 29, **characterized in that** the digital camera (1) has a plastic body (5) that has a common plastic body (5) made from transparent plastic with the lens (2).

31. Digital camera according to one of Claims 19 to 30, **characterized in that** the transparent plastic body (5) is covered by a lightsafe film (18) while leaving free an opening (38) for the lens (2).

32. Digital camera according to one of Claims 25 to 31, **characterized in that** the semiconductor sensor (9) is mounted on the system carrier (19) with the aid of an adhesive (22), preferably a conductive adhesive.

33. Digital camera according to one of Claims 19 to 32, **characterized in that** the semiconductor sensor (9) is mounted on the underside (8) of the plastic body (5) by means of an adhesive (22).

34. Digital camera according to one of Claims 19 to 33, **characterized in that** the lens (2) is mounted on the plastic body (5) with the aid of an adhesive (22).

35. Digital camera according to one of Claims 28 to 34, **characterized in that** the external contact bumps are mounted on the underside (15) of the semiconductor sensor (9) by means of soldering material.

36. Digital camera according to one of Claims 28 to 35, **characterized in that** the external contact bumps have soldering material.

37. Method for producing a digital camera according to Claim 19, which has the following method steps:
- providing an injection mould that has at least one cavity for injection moulding a plastic plate (23) for a plurality of camera housings (3) of a digital camera (1), the plastic plate (23) having suitable openings on its top side (25) for holding a lens (2), and on its underside (26) for holding a semiconductor sensor (9),
- fitting the underside (26) of the plastic plate (23) with semiconductor sensors (9), rewiring structures (11) and external connections (13),
- filling up the plastic core (35) of the plastic body (5) with transparent adhesive, the plastic body (5) being produced from a light-absorbing material and surrounding a frustoconical transparent plastic core (35) at its centre (36),
- fitting the top side (25) of the plastic plate (23) with lenses (2) in the openings provided therefor, the fitting of the underside (26) of the plastic plate (23) with semiconductor sensors (9) that have external contact bumps being performed in the openings provided therefor by means of flip-chip technology,
- mounting a lightsafe mask (7), while leaving free each lens (2) on the top side (25) of the plastic plate (23), and
- separating the plastic plate (23) into individual digital cameras (1).

38. Method according to Claim 37, **characterized in that** the filling up of a frustoconical plastic core (35) is carried out under a vacuum.

39. Method for producing a digital camera according to Claim 1, having the following method steps:
- providing a system carrier (19) for a plurality of semiconductor sensors (9) and with leads for external connections,
- mounting semiconductor sensors (9) onto the system carrier,
- connecting contact surfaces (12) on the top side of the semiconductor sensor (9) to the external connections (13),
- potting the system carrier (19) with a transparent plastic to form a transparent lower plastic plate half (39) while embedding the system carrier (19), the external connections (13) and the connections (30) on the underside (26) of the plastic plate (30),
- selectively coating the top side of the lower plastic plate half (39) with an aperture plate layer (41),
- mounting an upper transparent plastic plate half (40), provided with dome-like protuberances (31) on the top side, onto the aperture plate layer (41), and
- separating the plastic plate into individual transparent digital cameras (56) with an integral lens (26) and built-in semiconductor sensor (9) as well as with external connections (13),
- mounting a lightsafe film (32) onto the outsides (42, 43, 44) of the transparent digital camera (56) while leaving free an opening for the lens (2) and openings for the external connections, the lightsafe film (32) being a shrink film that is shrunk as camera housing (3) onto the outsides of the transparent digital camera (56).

## Revendications

1. Appareil photographique numérique comprenant un objectif (2) qui présente un côté supérieur d'objectif (33) et un côté inférieur d'objectif (34), un boîtier d'appareil photographique (3) et un capteur photosensible (4) qui présente un côté supérieur (10) dirigé vers l'objectif (2) et un côté inférieur (15), le boîtier d'appareil photographique (3) présentant un corps en matière plastique (5) qui supporte l'objectif (2) sur son côté supérieur (6) et qui présente sur son côté inférieur (8) un capteur semi-conducteur (9) faisant office de capteur photosensible (4), l'appareil photographique (1) présentant un coeur (35) en matière plastique transparente qui remplit au moins un espace intermédiaire entre le côté inférieur d'objectif (34) et le côté supérieur (10) du capteur semi-conducteur (9) et une ouverture circulaire (14) entre le côté inférieur d'objectif (34) et le côté supérieur (10) du capteur semi-conducteur (9) étant disposée dans le coeur (35) en matière plastique transparente, le corps (5) en matière plastique transparente étant recouvert d'un film de protection contre la lumière (7) en laissant une ouverture (38) pour l'objectif (2) et **caractérisé en ce que** le film de protection contre la lumière (7) est un film rétractable.

2. Appareil photographique numérique selon la revendication 1, **caractérisé en ce que** le capteur semi-conducteur (9) présente sur son côté supérieur (10) une matrice de cellules photosensibles dont les électrodes sont reliées par le biais de circuits intégrés avec des surfaces de contact (12) qui interagissent avec une structure de câblage (11) sur le côté inférieur du boîtier d'appareil photographique (3) et les bornes extérieures (13) qui s'y trouvent.

3. Appareil photographique numérique selon la revendication 1 ou la revendication 2, **caractérisé en ce que** le corps en matière plastique (5) est fabriqué à partir d'un matériau absorbant la lumière et entoure un coeur (35) en matière plastique transparente de forme tronconique en son centre (36).

4. Appareil photographique numérique selon l'une des revendications précédentes, **caractérisé en ce que** le corps en matière plastique (5) présente lui-même un matériau transparent à la lumière.

5. Appareil photographique numérique selon l'une des revendications précédentes, **caractérisé en ce que** l'ouverture (14) présente un diaphragme à trou (37) qui est disposé à un certain écart du côté supérieur de l'objectif (33), l'écart étant compris entre une moitié et un tiers de l'écart entre le côté supérieur de l'objectif (33) et le côté supérieur (10) du capteur semi-conducteur (9).

6. Appareil photographique numérique selon l'une des revendications précédentes, **caractérisé en ce que** la structure de câblage (11) est disposée sur le côté inférieur (8) du corps en matière plastique (5).

7. Appareil photographique numérique selon l'une des revendications 1 à 6, **caractérisé en ce que** la structure de câblage (11) est disposée sur le côté inférieur (15) du capteur semi-conducteur (9).

8. Appareil photographique numérique selon l'une des revendications précédentes, **caractérisé en ce que** la structure de câblage (11) est un support de système (19) sur lequel est monté le capteur semi-conducteur (9).

9. Appareil photographique numérique selon l'une des revendications précédentes, **caractérisé en ce que** l'objectif (2) est entouré d'un masque de protection contre la lumière (7).

10. Appareil photographique numérique selon l'une des revendications précédentes, **caractérisé en ce que** la structure de câblage (11) présente des pistes conductrices qui relient les surfaces de contact (12) du capteur semi-conducteur (9) avec les bornes extérieures (13) sur le côté inférieur de l'appareil photographique numérique (1).

11. Appareil photographique numérique selon l'une des revendications précédentes, **caractérisé en ce que** les bornes extérieures (13) présentent des bosses de contact.

12. Appareil photographique numérique selon l'une des revendications précédentes, **caractérisé en ce que** l'appareil photographique numérique (1) présente comme structure de câblage (11) un support de système (19) qui supporte le capteur semi-conducteur (9) et présente des bornes extérieures électriques (13), les surfaces de contact (12) du capteur semi-conducteur (9) étant reliées avec les bornes extérieures (13) par le biais de liaisons fixes (30).

13. Appareil photographique numérique selon l'une des revendications précédentes, **caractérisé en ce que** l'appareil photographique numérique (1) présente un corps en matière plastique (5) qui présente avec l'objectif (2) un corps en matière plastique (5) commun en matière plastique transparente.

14. Appareil photographique numérique selon l'une des revendications 8 à 13, **caractérisé en ce que** le capteur semi-conducteur (9) est monté sur le support de système (19) avec un adhésif (22), de préférence un adhésif conducteur.

15. Appareil photographique numérique selon l'une des revendications précédentes, **caractérisé en ce que** le capteur semi-conducteur (9) est monté sur le côté inférieur (8) du corps en matière plastique (5) au moyen d'un adhésif (22).

16. Appareil photographique numérique selon l'une des revendications précédentes, **caractérisé en ce que** l'objectif (2') est monté sur le corps en matière plastique (5) avec un adhésif (22).

17. Appareil photographique numérique selon l'une des revendications 11 à 16, **caractérisé en ce que** les bosses de contact extérieures sont montées sur le côté inférieur (15) du capteur semi-conducteur (9) au moyen d'un matériau de brasage.

18. Appareil photographique numérique selon l'une des revendications 11 à 17, **caractérisé en ce que** les bosses de contact extérieures présentent un matériau de brasage.

19. Appareil photographique numérique comprenant un objectif (2) qui présente un côté supérieur d'objectif (33) et un côté inférieur d'objectif (34), un boîtier d'appareil photographique (3) et un capteur photosensible (4) qui présente un côté supérieur (10) dirigé vers l'objectif (2) et un côté inférieur (15), le boîtier d'appareil photographique (3) présentant un corps en matière plastique (5) qui supporte l'objectif (2) sur son côté supérieur (6) et qui présente sur son côté inférieur (8) un capteur semi-conducteur (9) faisant office de capteur photosensible (4), l'appareil photographique (1) présentant un coeur (35) en matière plastique transparente qui remplit au moins un espace intermédiaire entre le côté inférieur d'objectif (34) et le côté supérieur (10) du capteur semi-conducteur (9) et une ouverture circulaire (14) entre le côté inférieur d'objectif (34) et le côté supérieur (10) du capteur semi-conducteur (9) étant disposée dans le coeur (35) en matière plastique transparente, **caractérisé en ce que** le corps (5) en matière plastique présente un matériau absorbant la lumière et entoure dans son centre (36) un coeur (35) en matière plastique transparente de forme tronconique.

20. Appareil photographique numérique selon la revendication 19, **caractérisé en ce que** le capteur semi-conducteur (9) présente sur son côté supérieur (10) une matrice de cellules photosensibles dont les électrodes sont reliées par le biais de circuits intégrés avec des surfaces de contact (12) qui interagissent avec une structure de câblage (11) sur le côté inférieur du boîtier d'appareil photographique (3) et les bornes extérieures (13) qui s'y trouvent.

21. Appareil photographique numérique selon la revendication 19 ou 20, **caractérisé en ce que** le corps en matière plastique (5) présente lui-même un matériau transparent à la lumière.

22. Appareil photographique numérique selon l'une des revendications 19 à 21, **caractérisé en ce que** l'ouverture (14) présente un diaphragme à trou (37) qui est disposé à un certain écart du côté supérieur de l'objectif (33), l'écart étant compris entre une moitié et un tiers de l'écart entre le côté supérieur de l'objectif (33) et le côté supérieur (10) du capteur semi-conducteur (9).

23. Appareil photographique numérique selon l'une des revendications 19 à 22, **caractérisé en ce que** la structure de câblage (11) est disposée sur le côté inférieur (8) du corps en matière plastique (5).

24. Appareil photographique numérique selon l'une des revendications 19 à 23, **caractérisé en ce que** la structure de câblage (11) est disposée sur le côté inférieur (15) du capteur semi-conducteur (9).

25. Appareil photographique numérique selon l'une des revendications 19 à 24, **caractérisé en ce que** la structure de câblage (11) est un support de système (19) sur lequel est monté le capteur semi-conducteur (9).

26. Appareil photographique numérique selon l'une des revendications 19 à 25, **caractérisé en ce que** l'objectif (2) est entouré d'un masque de protection contre la lumière (7).

27. Appareil photographique numérique selon l'une des revendications 19 à 26, **caractérisé en ce que** la structure de câblage (11) présente des pistes conductrices qui relient les surfaces de contact (12) du capteur semi-conducteur (9) avec les bornes extérieures (13) sur le côté inférieur de l'appareil photographique numérique (1).

28. Appareil photographique numérique selon l'une des revendications 19 à 27, **caractérisé en ce que** les bornes extérieures (13) présentent des bosses de contact.

29. Appareil photographique numérique selon l'une des revendications 19 à 28, **caractérisé en ce que** l'appareil photographique numérique (1) présente comme structure de câblage (11) un support de système (19) qui supporte le capteur semi-conducteur (9) et présente des bornes extérieures électriques (13), les surfaces de contact (12) du capteur semi-conducteur (9) étant reliées avec les bornes extérieures (13) par le biais de liaisons fixes (30).

30. Appareil photographique numérique selon l'une des revendications 19 à 29, **caractérisé en ce que** l'appareil photographique numérique (1) présente un corps en matière plastique (5) qui présente avec l'objectif (2) un corps en matière plastique (5) commun en matière plastique transparente.

31. Appareil photographique numérique selon l'une des revendications 19 à 30, **caractérisé en ce que** le corps (5) en matière plastique transparente est recouvert d'un film de protection contre la lumière (18) en laissant une ouverture (38) pour l'objectif (2).

32. Appareil photographique numérique selon l'une des revendications 25 à 31, **caractérisé en ce que** le capteur semi-conducteur (9) est monté sur le support de système (19) avec un adhésif (22), de préférence un adhésif conducteur.

33. Appareil photographique numérique selon l'une des revendications 19 à 32, **caractérisé en ce que** le capteur semi-conducteur (9) est monté sur le côté inférieur (8) du corps en matière plastique (5) au moyen d'un adhésif (22).

34. Appareil photographique numérique selon l'une des revendications 19 à 33, **caractérisé en ce que** l'objectif (2) est monté sur le corps en matière plastique (5) avec un adhésif (22).

35. Appareil photographique numérique selon l'une des revendications 28 à 34, **caractérisé en ce que** les bosses de contact extérieures sont montées sur le côté inférieur (15) du capteur semi-conducteur (9) au moyen d'un matériau de brasage.

36. Appareil photographique numérique selon l'une des revendications 28 à 35, **caractérisé en ce que** les bosses de contact extérieures présentent un matériau de brasage.

37. Procédé de fabrication d'un appareil photographique numérique selon la revendication 19, comprenant les étapes suivantes :
- Mise à disposition d'un moule de moulage par injection qui présente au moins une cavité pour le moulage par injection d'une plaque en matière plastique (23) pour plusieurs boîtiers d'appareil photographique (3) d'un appareil photographique numérique (1), la plaque en matière plastique (23) présentant des ouvertures appropriées sur son côté supérieur (25) pour accueillir un objectif (2) et sur son côté inférieur (26) pour accueillir un capteur semi-conducteur (9) ;
- Implantation sur le côté inférieur (26) de la plaque en matière plastique (23) de capteurs semi-conducteurs (9), de structures de câblage (11) et de bornes extérieures (13) ;
- Remplissage du coeur en matière plastique (35) du corps en matière plastique (5) d'adhésif transparent, le corps en matière plastique (5) étant fabriqué à partir d'un matériau absorbant la lumière et entourant un coeur (35) en matière plastique transparente de forme tronconique en son centre (36) ;
- Implantation sur le côté supérieur (25) de la plaque en matière plastique (23) d'objectifs (2) dans les ouvertures prévues à cet effet, l'implantation de capteurs semi-conducteurs (9) qui présentent des bosses de contact extérieures sur le côté inférieur (26) de la plaque en matière plastique (23) s'effectuant au moyen de la technologie Flip-Chip dans les ouvertures prévues à cet effet ;
- Application d'un masque de protection contre la lumière (7) en laissant dégagé chaque objectif (2) sur le côté supérieur (25) de la plaque en matière plastique (23) ;
- Division de la plaque en matière plastique (23) en appareils photographiques numériques (1) individuels.

38. Procédé selon la revendication 37, **caractérisé en ce que** le remplissage d'un coeur (35) en matière plastique de forme tronconique est réalisé sous vide.

39. Procédé de fabrication d'un appareil photographique numérique selon la revendication 1, comprenant les étapes suivantes :
- Mise à disposition d'un support de système (19) pour plusieurs capteurs semi-conducteurs (9) et comprenant des conducteurs plats pour des bornes extérieures ;
- Application de capteurs semi-conducteurs (9) sur le support de système ;
- Connexion des surfaces de contact (12) sur le côté supérieur du capteur semi-conducteur (9) avec les bornes extérieures (13) ;
- Scellement du support de système (19) dans une matière plastique transparente pour former une moitié inférieure (39) de plaque en matière plastique transparente en insérant le support de système (19), les bornes extérieures (13) et les connexions (30) sur le côté inférieur (26) de la plaque en matière plastique (30) ;
- Revêtement sélectif du côté supérieur de la moitié inférieure de plaque en matière plastique (39) avec une couche de diaphragme à trou (41) ;
- Application sur la couche de diaphragme à trou (41) d'une moitié de plaque en matière plastique (40) supérieure transparente munie sur le côté supérieur de bossages (31) en forme de dôme ;
- Division de la plaque en matière plastique en appareils photographiques numériques (56) transparents individuels avec objectif (2) intégré et capteur semi-conducteur (9) incorporé et aussi munis de bornes extérieures (13).
- Application d'un film de protection contre la lumière (32) en laissant une ouverture pour l'objectif (2) et des ouvertures pour les bornes extérieures sur les côtés extérieurs (42, 43, 44) de l'appareil photographique numérique (56) transparent, le film de protection contre la lumière (32) étant un film rétractable qui est rétracté sur les côtés extérieurs de l'appareil photographique numérique (56) transparent en tant que boîtier d'appareil photographique (3).
